# EUROPEAN PATENT SPECIFICATION

(11) **EP 1 997 620 B1**
(45) Date of publication and mention of the grant of the patent: **15.06.2016**
(21) Application number: 07738668.8
(22) Date of filing: 15.03.2007
(51) Int. Cl.: C23C 16/02, C23C 16/26, B32B 9/04

(54) **LAMINATED BODY AND CARBON FILM DEPOSITION METHOD**
LAMINATKÖRPER UND VERFAHREN ZUR KOHLESCHICHTAUFTRAGUNG
CORPS STRATIFIÉ ET PROCÉDÉ DE DÉPÔT DE FILM DE CARBONE ASSOCIÉ

(30) Priority: 17.03.2006 JP 2006074038; 01.09.2006 JP 2006237740
(43) Date of publication of application: 03.12.2008
(73) Proprietor: National Institute of Advanced Industrial Science and Technology, Tokyo 100-8921 (JP)
(72) Inventor: HASEGAWA, Masataka, Tsukuba-shi, Ibaraki 305-8565 (JP); TSUGAWA, Kazuo, Tsukuba-shi, Ibaraki 305-8565 (JP); ISHIHARA, Masatou, Tsukuba-shi, Ibaraki 305-8565 (JP); KOGA, Yoshinori, Tsukuba-shi, Ibaraki 305-8565 (JP)
(74) Representative: Zimmermann & Partner Patentanwälte mbB
(86) International application number: PCT/JP2007/055218
(87) International publication number: WO 2007/108394

(56) References cited:
- EP-A1- 1 748 091
- EP-A1- 1 754 684
- WO-A1-2005/103326
- JP-A- 07 118 853
- JP-A- 07 118 853
- GAO KELIN ET AL: "Characteristics of the plasma during chemical vapor deposition for diamond growth" CHINESE PHYSICS LETTERS, vol. 9, no. 3, 1992, pages 144-147, XP002576359 Institute of Physics, Chinese Academy of Sciences, Beijing [CN] ISSN: 0256-307X
- TAMOR M A ET AL: "Raman 'fingerprinting' of amorphous carbon films", JOURNAL OF APPLIED PHYSICS, vol. 76, no. 6, 15 September 1994 (1994-09-15), pages 3823-3830, XP000470082, AMERICAN INSTITUTE OF PHYSICS, MELVILLE, NY [US] ISSN: 0021-8979, DOI: 10.1063/1.357385
- SHAMSA M ET AL: "Thermal conductivity of diamond-like carbon films", APPLIED PHYSICS LETTERS, vol. 89, no. 16, 20 October 2006 (2006-10-20), pages 161921-161921, XP012086414, AMERICAN INSTITUTE OF PHYSICS, MELVILLE, NY [US] ISSN: 0003-6951, DOI: 10.1063/1.2362601
- PAK S Y ET AL: "Synergistic improvement of thermal conductivity of thermoplastic composites with mixed boron nitride and multi-walled carbon nanotube fillers", CARBON, vol. 50, no. 13, 13 June 2012 (2012-06-13) , pages 4830-4838, XP055230556, Elsevier [GB] ISSN: 0008-6223, DOI: 10.1016/j.carbon.2012.06.009

## Description

### TECHNICAL FIELD

The present invention relates to a method for depositing a carbon film on a substrate containing a resin material.

### BACKGROUND ART

In recent years, resin materials are used everywhere in life. In particular, recently many materials called engineering plastics having excellent characteristics compared with the conventional resin materials are developed. For example, a polyphenylene sulfide (hereinafter referred to as PPS) resin described hereinafter is one of those.

PPS resin is a crystalline polymer having a melting point of about 280°C, and is a flame retardant resin having excellent characteristics in heat resistance and rigidity, as well as chemical resistance, dimensional stability, electric characteristics, mechanical properties, injection moldability and the like. Furthermore, PPS obtains high heat resistance, strength, rigidity and excellent dimensional stability by reinforcing the same with glass fibers, carbon fibers or inorganic fillers, and simultaneously is put into practical use as heat-resistant engineering plastics having excellent mold processability as a thermoplastic resin.

Thus, demand is greatly increased in fields of response to miniaturization of electronic parts due to improvement of precision moldability; improvement in fuel efficiency of automobiles; semiconductors; personal computers; mobile phones; multimedia relations; automobile, electric and electronic parts by substitution with metals such as zinc or aluminum die-cast, or thermosetting resins represented by phenolic resins; and the like.

PPS resin products are prospected to greatly enlarge the applications as described above, and are resins making metal substitution possible. Therefore, the PPS resin products are expected to play an important role for reduction in weight of automobiles and electronic instruments in the future. However, to widely utilize the PPS resin products to those applications, it is necessary to further increase thermal conductivity and slidability, as well as heat resistance, strength and rigidity, of PPS resin products.

Furthermore, the improvement of characteristics as above is desired in not only PPS resin products, but in almost all of resins.

On the other hand, diamond having characteristics such as high thermal conductivity, slidability, strength or rigidity is already known (Patent Document 1 or the like), and it has been desired as a laminate material for improving characteristics even in the above-described resin materials. For example, if it is possible to laminate a diamond film on a PPS resin injection molded material, a thermal conductivity and slidability, as well as heat resistance, strength and rigidity, of PPS resin products will be further increased. However, a process for laminating a diamond film requires holding a temperature of a substrate to which lamination is carried out at high temperature of generally 800°C or higher. There has conventionally been the problem that it is impossible to improve the characteristics by laminating a diamond film on a resin material that cannot withstand such high temperature. Therefore, in place of lamination of a diamond film, development of a laminate having improved thermal conductivity and slidability, as well as heat resistance, strength and rigidity, of a resin material, and capable of laminating at low temperature, and the method have been desired.

Furthermore, it is general to use a plasma chemical vapor deposition (CVD) to lamination of a diamond film or deposition of a carbon film having excellent characteristic as described in Patent Document 1. In this case, a starting gas is generally a mixed gas of hydrogen and methane, and a mixing ratio of hydrogen gas is generally 90% or more. Therefore, in a lamination process, a resin material is exposed to a large amount of hydrogen plasma. However, reactivity of hydrogen plasma is very high, and therefore there has been a problem that the resin material is damaged by the reaction with hydrogen plasma.

Furthermore, there has been a problem that a resin material of a substrate melts by the heating from plasma during plasma CVD treatment. Where the treatment temperature is set to low temperature to avoid this, there has been a problem that deposition of a diamond film or a carbon film becomes difficult.

Patent Document 1: WO2005/103326 Pamphlet

In the Chinese Physical Letter, Vol. 9, No 3(1992) 144, the relationships between plasma parameters and the concentration of hydrocarbon, the power, pressure and the gas flow rate are disclosed during the course of diamond growth by DC plasma CVD and microwave plasma CVD.

JP 07-118 853 discloses the production of organic polymer having a diamond film. A plasma resistant protective film is formed on a substrate consisting of a heat resistant organic polymer material.

EP 1 754 681 A1 pertains to a method of activating a DLC film by a plasma process and subsequent use for polymerization of monomers on the surface of the DLC film.

### DISCLOSURE OF THE INVENTION

### Problems that the Invention is to Solve

The present invention has been made in view of the above circumstances, and an object thereof is to provide a laminate of a carbon film and a resin, having imparted thereto higher characteristics on thermal conduction characteristic, rigidity, scratch resistance and slidability possessed by a resin material, and a method for depositing a carbon film on a substrate containing a resin material.

### - Means for Solving the Problems

As a result of earnest studies to achieve the above object, the present inventors have found that by depositing a carbon film having high thermal conductivity, rigidity, scratch prevention and high slidability on a resin material, a laminate of a carbon film and a resin, having imparted thereto higher characteristics on thermal conduction characteristic, rigidity, scratch resistance and slidability possessed by the resin material can be formed. They have further found that by mixing argon gas and/or hydrogen gas each having low reactivity with a reaction gas, using extremely low gas pressure and additionally utilizing low electron temperature plasma, a carbon film can be deposited without giving damage to a resin material as a substrate or melting a substrate.

The present invention has been reached to complete on the basis of those findings, and is as defined in claim 1:
A method for depositing a carbon film on a substrate containing a resin material providing a maximal surface roughness of 3.5 µm or less is provided. The method comprises introducing, as a reaction gas, a mixed gas of a carbon-containing gas and an argon gas and/or a hydrogen gas into a microwave plasma CVD reactor, generating a plasma at a gas pressure of from 1 to 100 pascals, placing the substrate at a position at which an electron temperature of the plasma is from 0.5 to 3.0 eV, and moving radical species in the plasma toward the substrate from a generation source of the plasma such that the radical species almost uniformly reach on a surface of the substrate.

Preferred embodiments are defined in claims 2 to 4.

The invention can be used for obtaining a laminate in any of the following examples.
(1) A laminate comprising:
   a resin material; and
   a carbon film having a thermal conductivity of from 70 to 700 W/mK, a resistance value of 1 × 10⁷ Ωcm or more (at 100°C) and a film thickness of from 50 nm to 10 µm,
   wherein the carbon film has a spectrum peak at a Brag's angle (2θ ± 0.3°) of from 41 to 42° in an X-ray diffraction spectrum by CuK_{α1} ray.
(2) A laminate comprising:
   a resin material;
   a plasma-resistant film; and
   a carbon film having a thermal conductivity of from 70 to 700 W/mK, a resistance value of 1 × 10⁷ Ωcm or more (at 100°C) and a film thickness of from 50 nm to 10 µm,
   wherein the carbon film has a spectrum peak at a Brag's angle (2θ ± 0.3°) of from 41 to 42° in an X-ray diffraction spectrum by CuK_{α1} ray.
(3) The laminate according to (1) or (2), wherein the resin material has a maximum surface roughness of 3.5 µm or less.
(4) The laminate according to (1) or (2), wherein the carbon film has a maximum surface roughness of 20 nm or less.
(5) The laminate according to (2), wherein the plasma-resistant film is at least one member selected from metals or alloys, such as gold, silver, copper, titanium, aluminum, iron, stainless steel or molybdenum; ceramics such as tungsten carbide, alumina or boron nitride; silicon, sapphire, quartz, SiO₂, glass, and diamond-like carbon.
(6) The laminate according to (2), wherein the resin material and the plasma-resistant film are molded integrally.
(7) The laminate according to (1) or (2), wherein the resin material is any one of resins such as polyphenylene sulfide, polycarbonate, polyethylene terephthalate or polyether sulfone; or the resins containing a carbon fiber, a glass fiber, an inorganic filler or the like.

### Advantage of the Invention

The laminate of a carbon film and a resin as obtainable by the invention can further increase thermal conductivity and slidability, as well as heat resistance, strength and rigidity, of the conventional resin materials. Furthermore, in the case that a film having plasma resistance is laminated on the resin material, damage of the resin material by hydrogen plasma can be prevented. Moreover, according the method for depositing a carbon film of the invention, not only damage of the resin material used as a substrate by plasma can be prevented, but melting and thermal deformation of the resin material can be prevented.

### BRIEF DESCRIPTION OF THE DRAWINGS

Fig. 1 is a cross-sectional view showing an outline of the laminate of a carbon film and a resin (PPS material) as obtainable by the invention.
Fig. 2 is a cross-sectional view showing an outline of the laminate of a carbon film, a plasma-resistant film (titanium) and a resin (PPS material) as obtainable by the invention.
Fig. 3 is a cross-sectional view showing an outline of the laminate of a carbon film, a plasma-resistant film (SiO₂) and a resin (PPS material) as obtainable by the invention.
Fig. 4 is a view showing the constitution of an apparatus for producing the laminate of a carbon film and a resin according to the invention.
Fig. 5 is a view showing dependence of distance from the lower surface (CVD reactor side) of a quartz window for microwave introduction, on electron temperature (kinetic energy of electron) in plasma, obtained by plasma characteristic measurement using Langmuir probe.
Fig. 6 is a view showing dependence of distance from the lower surface (CVD reactor side) of a quartz window for microwave introduction, on plasma density.
Fig. 7 is a Raman spectral chart showing formation of a carbon film on PPS substrate having laminated thereon a plasma-resistant film (Ti).
Fig. 8 is a Raman spectral chart showing formation of a carbon film on PPS substrate having laminated thereon a plasma-resistant film (Cu).
Fig. 9 is a Raman spectral chart showing formation of a carbon film on PPS substrate which does not have a plasma-resistant film.
Fig. 10 is a view showing an X-ray diffraction spectrum by CuK_{α1} of a carbon film as one example of the invention, and a peak fitting result.
Fig. 11 is a view showing a typical X-ray diffraction spectrum ((111) reflection peak) by CuK_{α1} in diamond, and a peak fitting result.

### Description of Reference Numerals and Signs

- 101: Plasma generating chamber
- 102: Slotted square waveguide tube
- 103: Quartz window for introducing microwave
- 104: Metal-made supporting frame for supporting quartz window
- 105: Substrate to be film-formed thereon
- 106: Specimen holder for placing a substrate to be film-formed thereon
- 107: Supply and drain of cooling water
- 108: Evacuation
- 109: Pipe for introducing gas for plasma generation
- 110: Reactor

### BEST MODE FOR CARRYING OUT THE INVENTION

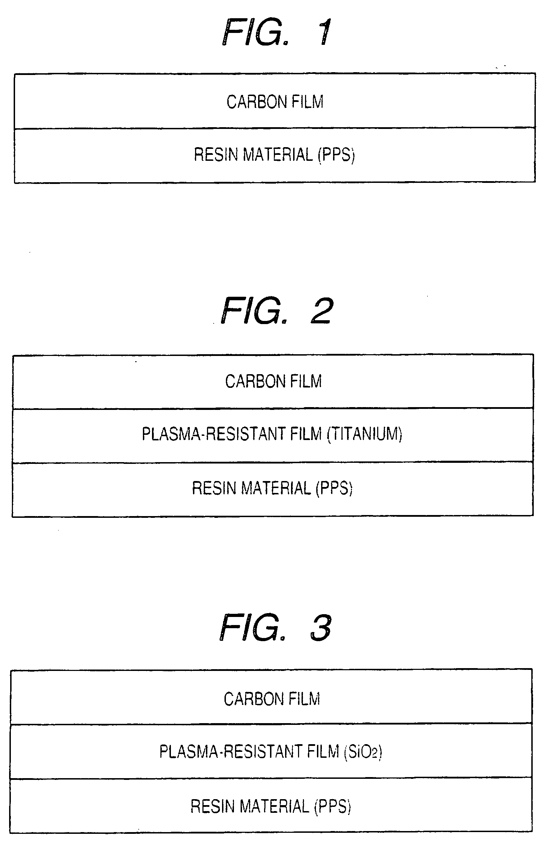

Fig. 1 is a cross-sectional view showing an outline of the laminate of a carbon film and a resin (PPS material) obtainable by the present invention, Fig. 2 is a cross-sectional view showing an outline of the laminate of a carbon film, a plasma-resistant film (titanium) and a resin (PPS material) of the invention, and Fig. 3 is a cross-sectional view showing an outline of the laminate of a carbon film, a plasma-resistant film (SiO₂) and a resin (PPS material) obtainable by the invention.

The laminate of a carbon film and a resin obtainable by the invention is a laminate obtained by laminating a resin material and a carbon film having a thermal conductivity of from 70 to 700 W/mK, a resistance value of 1 × 10⁷ Ωcm or more (at 100°C) and a film thickness of from 50 nm to 10 µm, the carbon film having a spectrum peak at a Brag's angle (20 ± 0.3°) of from 41 to 42° in an X-ray diffraction spectrum by CuK_{α1} ray.

Furthermore, the laminate of carbon film and a resin obtainable by the invention is a laminate obtained by laminating a resin material, a plasma-resistant film, and a carbon film having a thermal conductivity of from 70 to 700 W/mK, a resistance value of 1 × 10⁷ Ωcm or more (at 100°C) and a film thickness of from 50 nm to 10 µm, the carbon film having a spectrum peak at a Brag's angle (20 ± 0.3°) of from 41 to 42° in an X-ray diffraction spectrum by CuK_{α1} ray.

It is preferred that the plasma-resistant film in the invention uses at least one member selected from metals or alloys, such as gold, silver, copper, titanium, aluminum, iron, stainless steel or molybdenum; ceramics such as tungsten carbide, alumina or boron nitride; silicon, sapphire, quartz, SiO₂, glass, and diamond-like carbon, and is molded integrally with the resin material.

The resin material in the invention uses any one of resins such as polyphenylene sulfide, polycarbonate, polyethylene terephthalate or polyether sulfone; or the resins containing carbon fibers, glass fibers, inorganic fillers or the like.

In plasma CVD treatment used for the formation of a carbon film on a substrate containing a resin material, the resin material is exposed to a large amount of hydrogen plasma. As a result, since reactivity of hydrogen plasma is very high, the surface of the resin material may be damaged by the reaction with hydrogen plasma.

In such a case, to prevent damage of the resin material by hydrogen plasma, it is effective to conduct lamination treatment of a film having plasma-resistant properties to the resin material. Metals such as gold, silver, copper, titanium, aluminum, iron, stainless steel or molybdenum; ceramics such as tungsten carbide, alumina or boron nitride; silicon, SiO₂, quartz, glasses, diamond-like carbon, and the like are suitable as a surface coating layer having plasma-resistant properties. Metals such as gold, silver, copper, titanium, aluminum, iron, stainless steel or molybdenum are preferably laminated by a vacuum deposition method or a sputtering method. Alternatively, a method of previously inserting those metal films in a mold in injection molding of a resin material, followed by integrally molding the metal films together with the resin material is also suitable. It is suitable that ceramics such as tungsten carbide, alumina or boron nitride are laminated by sputtering. Furthermore, it is suitable that silicon, SiO₂, quartz, glass, diamond-like carbon and the like are laminated by a CVD treatment, a coating and drying method, a sputtering method or the like. It is suitable that the thickness of those surface coatings having plasma-resistant properties is from 100 nm to 2 µm.

Where the surface roughness of a resin material is large, damage by hydrogen and other plasma is significant. In particular, it was found from the observation of the surface of a resin material in a region of 10 µm × 10 µm using an atomic force microscope that damage by hydrogen plasma is significant when the surface average roughness exceeds 3.5 µm. Therefore, the maximum surface roughness of a resin material allowable to prevent plasma damage is 3.5 µm, and using a resin material having a surface roughness not exceeding this as a substrate is effective to prevent plasma damage.

It is preferred in the invention that as a pre-treatment of the plasma CVD treatment, nanocrystalline diamond particles, cluster diamond particles or graphite cluster diamond particles are adhered to a resin material or a resin material having laminated thereon a plasma-resistant film; or adamantane (C₁₀H₁₆), its derivative or its multimer is adhered thereto.

In general, nanocrystalline diamond particles are diamond produced by explosion synthesis or by crushing diamond synthesized at high temperature and high pressure. Cluster diamond particles are aggregate of nanocrystalline diamond particles, and graphite cluster diamond particles are cluster diamond particles containing a large amount of graphite or amorphous carbon component.

The nanocrystalline diamond is already sold as, for example, a colloidal solution of nanocrystalline diamond by explosion synthesis dispersed in a solvent from NanoCarbon Research Institute Co., Ltd., or the like, or nanocrystalline diamond powder produced by crushing or the powder dispersed in a solvent from Tomei Diamond Co., Ltd., or the like. The nanocrystalline diamond particles used in the invention have an average particle diameter of from 4 to 100 nm, and preferably from 4 to 10 nm. The nanocrystalline diamond particles are described in detail in, for example, literatures such as Hiroshi Makita, New Diamond, Vol. 12, No. 3, pp. 8-13 (1996).

In the pre-treatment of adhering nanocrystalline diamond particles on a resin material or a resin material having laminated thereon a plasma-resistant film, the particles are firstly dispersed in water or ethanol. In this case, to improve dispersibility, a surfactant (for example, laurylsulfuric ester sodium salt or sodium oleate) is added, a substrate is dipped in this dispersion, and then subjected to an ultrasonic washer, and after the substrate was dipped in ethanol to conduct ultrasonic washing, the substrate is taken out and dried.

Thus, a resin material or a resin material having laminated thereon a plasma-resistant film, having been subjected to the pre-treatment of adhering nanocrystalline diamond particles to the surface thereof, can be obtained. Adhesion of the nanocrystalline diamond particles to the resin material or the resin material having laminated thereon a plasma-resistant film is due to that a part of the particles is embedded in the substrate surface by physical force in ultrasonic washing treatment.

Adhesion proportion of the nanocrystalline diamond particles to the substrate surface is preferably from 10⁹ to 10¹², and more preferably from 10¹⁰ to 10¹¹, per 1 cm². The diamond particles adhered to the resin material or the resin material having laminated thereon a plasma-resistant film act as seed crystals of growth of a carbon film in plasma CVD treatment.

In this case, by diluting the concentration of the nanocrystalline diamond particles dispersed in a dispersant (water, ethanol or the like), the adhesion proportion of the nanocrystalline diamond particles adhered to the substrate surface can be decreased. Accordingly, in the plasma CVD treatment, nucleus generation density of carbon particles can be decreased, and not a continuous film but a discontinuous film comprising an agglomerate carbon particles can be obtained. Area density of the carbon particles in the agglomerate can be controlled by the concentration of nanocrystalline diamond particles in the dispersion. Furthermore, the particle diameter of the carbon particles can be controlled by the time of conducting plasma CVD treatment. Agglomerate comprising carbon particles isolated on a substrate can be prepared by diluting the concentration significantly. Furthermore, carbon particles can be obtained solely by removing a substrate from the agglomerate by, for example, treating the agglomerate with an organic solvent or the like.

A method of spin coating a dispersion of the nanocrystalline diamond on the substrate, followed by drying, is also effective as an alternative method for the pre-treatment method of adhering nanocrystalline diamond particles on the substrate. The pre-treatment method using the spin coating can obtain the same adhesion effect as in the above method by ultrasonic washing.

Cluster diamond particles are agglomerates of nanocrystalline diamond produced by an explosion synthesis method, have excellent transparency, and are already sold from, for example, Tokyo Diamond Tools Mfg., Co., Ltd. The cluster diamond particles used in the invention have a particle size distribution of preferably from 4 to 100 nm, and more preferably from 4 to 10 nm. The cluster diamond particles are described in detail in the literature: Hiroshi Makita, New Diamond, Vol. 12, No. 3, pp. 8-13 (1996).

In the pre-treatment of adhering cluster diamond particles on a resin material or a resin material having laminated thereon a plasma-resistant film, the particles are firstly dispersed in water or ethanol. In this case, to improve dispersibility, a surfactant (for example, laurylsulfuric ester sodium salt or sodium oleate) is added, a substrate is dipped in this dispersion, and then treated in an ultrasonic washer, and after the substrate was cleaned in ethanol by ultrasonic washing, the substrate is taken out and dried.

Thus, a resin material or a resin material having laminated thereon a plasma-resistant film, having adhered to the surface thereon the cluster diamond particles, can be obtained. Adhesion of the cluster diamond particles to the resin material or the resin material having laminated thereon a plasma-resistant film is due to that a part of the particles is embedded in the substrate surface by physical force in ultrasonic washing treatment.

Adhesion proportion of the cluster diamond particles to the substrate surface is preferably from 10⁹ to 10¹², and more preferably from 10¹⁰ to 10¹¹, per 1 cm². The diamond particles adhered to the resin material or the resin material having laminated thereon a plasma-resistant film act as seed crystals of growth of a carbon film in plasma CVD treatment.

In this case, by diluting the concentration of the cluster diamond particles to be dispersed in a dispersant (water, ethanol or the like), the adhesion proportion of the cluster diamond particles adhered to the substrate surface can be decreased. Accordingly, in the plasma CVD treatment, nucleus generation density of carbon particles can be decreased, and not a continuous film but a discontinuous film comprising an agglomerate of carbon particles can be obtained. Area density of the carbon particles in the agglomerate can be controlled by the concentration of cluster diamond particles in the dispersion. Furthermore, the particle diameter of the carbon particles can be controlled by the time of conducting plasma CVD treatment. Agglomerate comprising carbon particles isolated on a substrate can be prepared by diluting the concentration significantly. Furthermore, carbon particles can be obtained solely by removing a substrate from the agglomerate by, for example, treating the agglomerate with an organic solvent or the like.

A method of spin coating a dispersion of the cluster diamond on the substrate, followed by drying, is also effective as an alternative method for the pre-treatment of adhering cluster diamond particles on the substrate. The pre-treatment method using the spin coating can obtain the same adhesion effect as in the above method by ultrasonic washing.

In the pre-treatment of adhering the graphite cluster diamond particles on a resin material or a resin material having laminated thereon a plasma-resistant film, the particles are firstly dispersed in water or ethanol. In this case, to improve dispersibility, a surfactant (for example, laurylsulfuric ester sodium salt or sodium oleate) is added, a substrate is dipped in this dispersion, and then treated in an ultrasonic washer, and after the substrate was cleaned in ethanol by ultrasonic washing, the substrate is taken out and dried.

Thus, a resin material or a resin material having laminated thereon a plasma-resistant film, having adhered to the surface thereon the graphite cluster diamond particles, can be obtained. Adhesion of the graphite cluster diamond particles to the resin material or the resin material having laminated thereon a plasma-resistant film is due to that a part of the particles is embedded in the substrate surface by physical force in ultrasonic washing treatment.

Adhesion proportion of the diamond particles to the substrate surface is preferably from 10⁹ to 10¹², and more preferably from 10¹⁰ to 10¹¹, per 1 cm². The diamond particles adhered to the resin material or the resin material having laminated thereon a plasma-resistant film act as seed crystals of growth of a carbon film in plasma CVD treatment.

In this case, by diluting the concentration of the graphite cluster diamond particles dispersed in a dispersant (water, ethanol or the like), the adhesion proportion of the graphite cluster diamond particles adhered to the substrate surface can be decreased. Accordingly, in the plasma CVD treatment, nucleus generation density of carbon particles can be decreased, and not a continuous film but a discontinuous film comprising an agglomerate of carbon particles can be obtained. Area density of the carbon particles in the agglomerate can be controlled by the concentration of the graphite cluster diamond particles in the dispersion. Furthermore, the particle diameter of the carbon particles can be controlled by the time of conducting plasma CVD treatment. Agglomerate comprising carbon particles isolated on a substrate can be prepared by diluting the concentration significantly. Furthermore, carbon particles can be obtained solely by removing a substrate from the agglomerate by, for example, treating the agglomerate with an organic solvent or the like. Furthermore, in the case that a continuous film is prepared on the substrate, a self-supported film can be prepared by the removal of the substrate.

A method of spin coating a graphite cluster diamond dispersion on the substrate, followed by drying, is effective as an alternative method for the pre-treatment of adhering the graphite cluster diamond particles on the substrate. The pre-treatment method using the spin coating can obtain the same adhesion effect as in the above method by ultrasonic washing.

Adamantane is a molecule represented by a molecular formula of C₁₀H₁₆, is a sublimation molecular crystal (ordinary temperature and ordinary pressure) having a steric structure similar to the basic skeleton of diamond, and is produced by petroleum refining process. Its powder, derivatives thereof and multimers thereof are already sold from Idemitsu Kosan Co., Ltd.

To adhere adamantine, derivatives thereof or multimers thereof on a resin material or a resin material having laminated thereon a plasma-resistant film, the material is dissolved in a solvent (for example, ethanol, hexane or acetonitrile), and after the substrate is dipped in the solution and then treated in ultrasonic washer, the substrate is taken out and dried. Thus, a resin material or a resin material having laminated thereon a plasma-resistant film, having adhered to the surface thereof adamantane, derivatives thereof or multimers thereof, can be obtained.

In this case, by diluting the concentration of adamantane, derivatives thereof or multimers thereof to be dissolved in a solvent, the adhesion proportion of adamantane, derivatives thereof or multimers thereof adhered to the substrate surface can be decreased. Accordingly, in the plasma CVD treatment, nucleus generation density of carbon particles can be decreased, and not a continuous film but a discontinuous film comprising an agglomerate of carbon particles can be obtained. Area density of the carbon particles in the agglomerate can be controlled by the concentration of adamantane, derivatives thereof or multimers thereof in the solution. Furthermore, the particle diameter of the carbon particles can be controlled by the time of conducting plasma CVD treatment. Agglomerate comprising carbon particles isolated on a substrate can be prepared by diluting the concentration significantly. Furthermore, carbon particles can be obtained solely by removing a substrate from the agglomerate by, for example, treating the agglomerate with an organic solvent or the like.

A method of spin coating the material solution on the substrate, followed by drying, is also effective as an alternative method for the pre-treatment of adhering adamantane, derivatives thereof or multimers thereof on the substrate. The pre-treatment method using the spin coating can obtain the same adhesion effect as in the above method by ultrasonic washing.

In the invention, the resin material or the resin material having laminated thereon a plasma-resistant film is treated using a microwave plasma CVD apparatus, or the resin material or the resin material having laminated thereon a plasma-resistant film is subjected to a pre-treatment, followed by a treatment using a microwave plasma CVD apparatus.

In this case, to avoid that the resin material suffers damage by plasma generated, it is necessary to select concentration or molar ratio of a starting gas, reaction time and the like as operation conditions, and to operate under relatively low temperatures. In the invention, the resin material is held at from room temperature to 200°C. Holding at such low temperature not only is effective to prevent plasma damage, but has a significant effect of preventing melting or thermal deformation of a resin material. The present invention is achieved by employing a method for depositing a carbon film, which comprises introducing a mixed gas of a carbon-containing gas and an argon gas and/or a hydrogen gas, as a reaction gas, into a microwave plasma CVD reactor; generating a plasma at a gas pressure of from 1 to 100 pascals; placing the substrate at a position at which an electron temperature of plasma is from 0.5 to 3.0 eV; and moving the plasma toward the substrate from a generation source of the plasma such that radical species in the plasma almost uniformly reach on a surface of the substrate, which contains a resin material providing a maximal surface roughness of 3.5 µm or less.

The present invention allows to obtain a laminate of a resin material and a carbon film, particularly formed by holding the resin material at from room temperature to 200°C and subjecting it to microwave plasma CVD treatment; and a method for forming the same. By using metals, ceramics, semiconductors or the like as a substrate, and expanding to a method of holding the substrate on a specimen holder at high temperature of from about 400 to 900°C, a diamond film can be deposited on the substrate such as metals, ceramics or semiconductors.

Furthermore, by using benzene, acetylene, toluene or methane gas having high concentration of 10% or more as a carbon source in a starting gas, this method can be expanded as a method of conducting deposition of a diamond-like carbon (DLC) film.

A method for producing a laminate of the invention is roughly described below by referring to an example.

For example, a pre-treatment is conducted by, according to need, providing a plasma-resistant film on a material such as polyphenylene sulfide (PPS), polycarbonate (PC), polyethylene terephthalate (PET) or polyether sulfone (PES), or further adhering diamond fine particles by ultrasonic treatment. The material thus pre-treated is subjected to plasma CVD treatment using a low temperature microwave plasma CVD apparatus by supplying radical species in plasma as a source of film formation in a down flow manner of moving the radical species toward a resin substrate placed on a specimen holder from the generation origin of the plasma such that the radical species almost uniformly reach on the surface of the resin substrate.

In the invention, the starting gas (reaction gas) used in CVD treatment is a mixed gas of a carbon-containing gas, and an argon gas and/or hydrogen. Examples of the carbon-containing gas include methane, ethanol, acetone and methanol.

The mixing ratio of the mixed gas suitable for film formation varies depending on the respective resin used in a substrate, and further varies depending on the state of surface treatment of a resin. The concentration of the carbon-containing gas is from 0.5 to 10 mol%, and preferably from 1 to 4 mol%. Where the carbon-containing gas is larger than the above range, the problem such as deterioration of light transmittance of a carbon film undesirably occurs.

It is preferred to add CO₂ or CO as an additive gas to the mixed gas. Those gases act as an oxygen source, and exhibit the function of removing impurities. The addition amount of CO₂ and/or CO is preferably from 0.5 to 10 mol%, and more preferably from 1 to 5 mol%, in the total mixed gas.

Addition of an argon gas and/or hydrogen is significantly effective to prevent plasma damage on the resin material surface. In particular, in the case that a plasma-resistant film is not provided on the surface of a resin, it is effective for the prevention of plasma damage to increase the proportion of an argon gas as compared with the proportion of hydrogen. It is preferred that the proportion of a hydrogen gas is from 0 to 95.5 mol%, and the proportion of an argon gas is from 0 to 95.5 mol%.

The plasma CVD treatment time is from several minutes to several ten hours, and the treatment temperature is from 20 to 300°C.

In the invention, a gas pressure of plasma CVD treatment and a position arranging a resin material are very important, and were confirmed as follows.

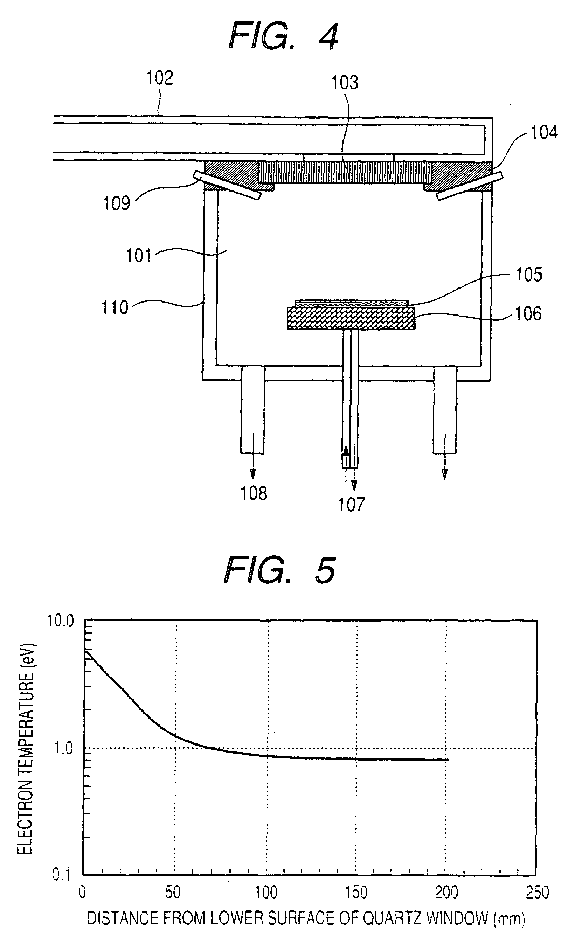

One example of the apparatus used for the formation of the laminate of a carbon film and a resin of the invention is shown in Fig. 4.

In Fig. 4, 101 is a microwave plasma CVD reactor (hereinafter simply referred to as a "plasma generation chamber"), 102 is a slotted square waveguide tube for introducing microwaves into the plasma generation chamber 101, 103 is a quartz window for introducing microwaves into the plasma generation chamber 101, 104 is a metal-made supporting frame for supporting the quartz window, 105 is a substrate to be film-formed, 106 is a specimen holder for placing the substrate to be film-formed, and is equipped with a vertical motion mechanism and a cooling system of the substrate to be film-formed, and 107 is supply and drain of the cooling water. Furthermore, 108 is evacuation, and 109 is a gas introduction pipe for plasma generation. Moreover, 110 is a reactor for conducting plasma CVD treatment.

Plasma generation using the apparatus is conducted as follows.

The plasma generation chamber 101 is vacuum evacuated by vacuum system (not shown). Subsequently, a gas for plasma generation is introduced into the plasma generation chamber 101 at a given flow rate through the gas introduction pipe 109. Next, a pressure control valve (not shown) provided in a vacuum apparatus is controlled to hold the inside of the plasma generation chamber 101 at a given pressure. Microwaves of the desired electric power are supplied in the plasma generation chamber 101 from 2.45 GHz microwave generating apparatus (not shown) through the slotted square waveguide tube 102 and the quartz member 103, whereby plasma is generated in the plasma generation chamber 101. Accordingly, radical species in plasma as a source of film formation can be supplied in a down flow manner by moving the radical species toward a resin substrate placed on a specimen holder from the generation origin of the plasma such that the radical species almost uniformly reach on the surface of the resin substrate.

Fig. 5 shows dependence of distance from the lower surface (CVD reactor side) of a quartz window for microwave introduction, on electron temperature (kinetic energy of electrons) in plasma, obtained by plasma characteristic measurement using Langmuir probe. The Langmuir probe used for this plasma characteristic measurement was probe system L2P for plasma diagnosis, a product of Kobe Steel, Ltd. In this case, to precisely measure plasma density of electrodeless discharge plasma of microwave excitation and electron temperature, measurement was conducted with a method called a double probe method, using two probes of platinum and tungsten. The Langmuir probe method is described in detail in, for example, the literature: Hideo Sugai, Plasma Electronics, Ohmsha, Ltd., 2000, p.58.

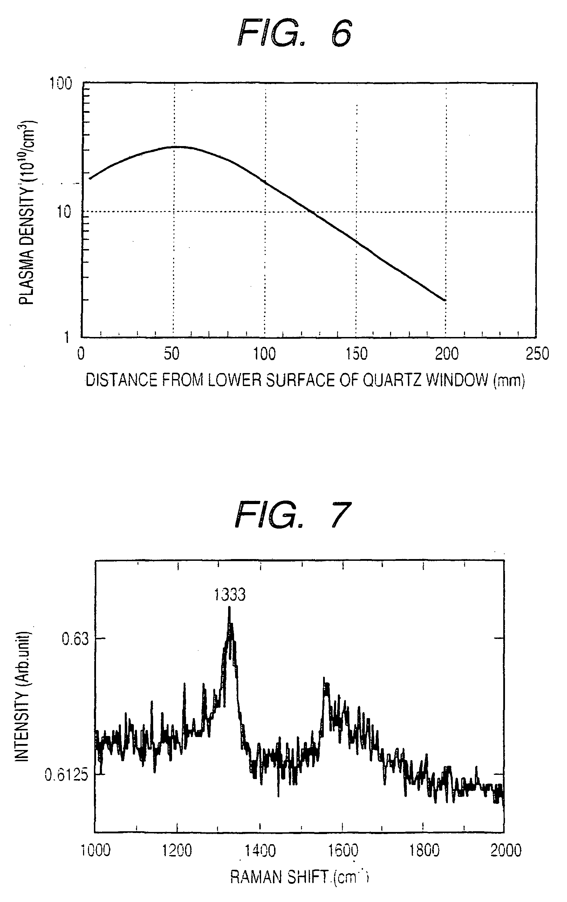

A gas used for measurement of this graph is 100% hydrogen, and pressure is 10 Pa. Thus, the electron temperature in plasma has the characteristic that the electron temperature is decreased with the increase of distance from a quartz window. Furthermore, Fig. 6 shows dependence of distance from the lower surface (CVD reactor side) of a quartz window for microwave introduction, on plasma density.

Other than the above measurements, electron temperature and plasma density were measured by mixing from 0.5 to 10 mol% of methane gas, from 0 to 10 mol% of carbon dioxide, 0 to 95.5 mol% of hydrogen gas and from 0 to 95.5 mol% of argon gas in optional proportions within those ranges. As a result, characteristics of plasma did not almost change in the gas mixing range measured.

A resin substrate was placed on a vertically movable specimen holder, so that the resin substrate could be arranged at an optional position from the quartz window. Based on the data of electron temperature in plasma shown in Fig. 5 and plasma density shown in Fig. 6, film formation tests were conducted by variously changing the position of the resin substrate at a gas pressure of 10 Pa, and conditions of optimum electron temperature and plasma density for film formation were searched.

As a result, it was found that a film was not formed at a position of the substrate that the electron temperature was 3 eV or higher, or not a carbon film of the invention but a soot-like film was merely deposited slightly. For example, at pressure of 10 Pa shown in Fig. 5, no film was formed or a soot-like film was merely deposited slightly at a region at a distance of 20 mm or less from a quartz window.

On the other hand, in a region that the electron temperature was 3 eV or lower, formation of a carbon film of the invention could be confirmed. For example, at a pressure of 10 Pa, it was confirmed that a film was formed in a region of from 20 to 200 mm from a quartz window. When a pressure was 10 Pa, the electron temperature in this region was from 3 to 0.8 eV.

Vertically movable range of the specimen holder used in this experiment is 200 mm at a maximum, and therefore, experiment at a distance larger than the distance could not be conducted. However, by devising the specimen holder, experiments at further large distance are possible.

In the region that the film formation was confirmed, the film-formation rate was the maximum at a distance from a quartz window of from 50 to 70 mm. This can be explained from that because plasma density is 50 mm at a maximum in dependence of distance on plasma density from a quartz window shown in Fig. 6, the film formation rate is the maximum at about 50 mm. Therefore, it was clarified that in the case that the film formation rate is desired to increase as possible, the optimum position of a resin material for film formation is a position where the electron temperature is 3 eV or lower and the plasma density becomes the maximum.

The above experiments were conducted under various gas pressures. As a result, it was found that the gas pressure suitable for the deposition of a carbon film is from 1 to 100 Pa, and preferably from 1 to 50 Pa. When the gas pressure was 200 Pa or more, film formation could not be confirmed. This is considered due to that because gas pressure is high, thermal damage, thermal expansion and thermal deformation of a resin substrate due to the heating from plasma are large. It was further clarified from those experiments that the optimum position of a resin material to film formation varies depending on gas pressure in plasma CVD treatment. It was clarified that when a resin material is placed at a position that the electron temperature of plasma is from 0.5 to 3 eV, a carbon film can be deposited on the resin substrate.

The reason that the position of a resin material suitable to film formation can be selected is due to that by moving radical species in plasma as a source of film formation toward a resin substrate placed on a specimen holder from the generation origin of plasma such that the radical species substantially uniformly reach on the surface of the resin substrate, distribution of the electron temperature so as to gradually decrease toward the substrate from the generation origin of the plasma as shown in Fig. 5 can be formed.

As a result of the observation of a carbon film deposited on the resin material as above with an optical microscope, it was clarified that it is difficult to uniformly form a carbon film on a resin material when film thickness is 50 nm or less. It was clarified that when the film thickness is 50 nm or more, it is possible to uniformly form a carbon film on a resin material, and when the film thickness is 100 nm or more, it is possible to further uniformly form a carbon film on the resin material. Furthermore, when film thickness was 10 µm or more, separation of the deposited carbon film from the resin material was liable to be generated. When the film thickness was 5 µm or less, a carbon film having adhesiveness sufficiently durable to adhesion strength test using a Scotch tape could be formed on the resin material. Therefore, the film thickness of the carbon film suitable to form a laminate of a resin material and a carbon film was from 50 nm to 10 µm, and preferably from 100 nm to 5 µm.

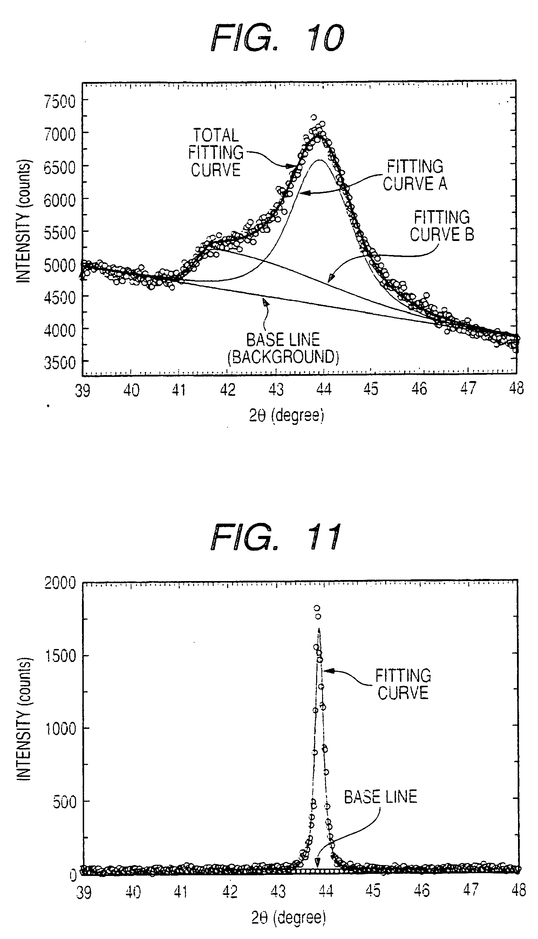

According to the invention, laminate of a carbon film and a resin material can be formed. The carbon film has the significant characteristics different from other carbon particles such as diamond and other carbon film such that the carbon film has an approximate spectrum curve obtained by superimposing peak fitting curve B at 41.7 ± 0.3° and a base line on peak fitting curve A at a Bragg's angle (2θ ± 0.3°) of 43.9° in an X-ray diffraction spectrum by CuK_{α1} ray as shown in Fig. 10.

Furthermore, in Raman scattering spectral spectrum (excitation light wavelength: 244 nm), a distinct peak is observed in the vicinity of a Raman shift of 1,333 cm⁻¹ as shown in Figs. 7 to 9, and its full width at half maximum (FWHM) is from 10 to 40 cm⁻¹. Furthermore, in the case of such a film, flatness and adhesiveness are excellent, and its surface roughness Ra is 20 nm or less. As the case may be, the surface is a flat surface having surface roughness reaching 3 nm or less. The film has optically excellent properties such that transparency is excellent, refraction index is very high as 2.1 or higher and birefringence is not almost shown, and further has electrically excellent properties such that its resistivity at a temperature of 100°C is 10⁷ Ωcm or more, thus showing very high electrical insulating properties.

Furthermore, it was seen from the observation of the film cross-section with a high resolution transmission type electron microscope that the film is formed by tightly packing crystalline carbon particles having a particle diameter of from 1 nm to several ten nm, and has the characteristic that its particle size distribution does not change (average particle diameter is substantially equal) at the interface between the film and the substrate, in the film and in the vicinity of the outermost surface of the film. The film thickness of the carbon film obtained is from 2 nm to 100 µm, preferably from 50 nm to 10 µm, and further preferably from 100 nm to 5 µm, and the particle diameter of the particle is preferably from 1 to 100 nm, and more preferably from 2 to 20 nm.

### Examples

The present invention is described more specifically below by reference to the Examples and the like, but the invention is not limited to those Examples and the like.

### (Example 1: Formation of carbon film on PPS resin substrate having provided thereon plasma-resistant film (Ti))

A material obtained by molding a polyphenylene sulfide (PPS) resin into a plate by injection molding was used as a substrate. Specifically, PPS resin TORELINA A504X90, a product of Toray Industries, Inc., was used as a PPS resin. This A504X90 is a PPS resin having been subjected thereto glass fiber reinforcement. This was injection molded using an injection molding apparatus having a degassing equipment (Model Number: ECOMAK HS100) in injection molding machine, a product of Haruna, mounted on an injection molding machine (Model Number: ROBOSHOT α-100IA), a product of Fanuc Ltd. The degassing equipment in injection molding machine, a product of Haruna, is an apparatus which removes outgas and water generated by resin raw materials during plasticizing in a cylinder of an injection molding machine. The PPS resin substrate had a shape of 100 mm × 100 mm and 2 mm thickness. An average surface roughness of the surface of the PPS resin substrate was 3.5 µm by the observation of a region of 10 µm × 10 µm using an atomic force microscope.

A titanium film having a thickness of 1 µm was formed as a plasma-resistant film on the surface of the PPS resin substrate by a sputtering method. A pre-treatment of adhering nanocrystalline diamond particles dispersed in water to the PPS resin substrate having the titanium plasma-resistant film formed thereon was conducted. That is, the PPS resin substrate was dipped in the dispersion and treated in an ultrasonic washer. Thereafter, the substrate was dipped in ethanol, followed by ultrasonic washing, and the substrate was taken out and dried. Thus, the PPS resin substrate having laminated thereon the plasma-resistant film having adhered on the surface thereof nanocrystalline diamond particles was obtained. Adhesion of the nanocrystalline diamond particles onto the PPS resin substrate having laminated thereof the plasma-resistant film is due to that a part of the particles is embedded in the surface of the substrate by physical force in the ultrasonic washing treatment. The diamond particles adhered to the PPS resin substrate having laminated thereof the plasma-resistant film act as seed crystals of the growth of a carbon film in plasma CVD treatment.

A carbon film was formed on the PPS resin substrate having been subjected to the above pre-treatment, using a plasma CVD apparatus shown in Fig. 4.

A gas used in the CVD treatment was composed of 90 mol% of hydrogen gas, 5 mol% of carbon dioxide and 5 mol% of methane gas. Plasma was generated at a gas pressure of 10 Pa, a substrate was placed at a position of 50 mm from a quartz window at which electron temperature of plasma is 1 eV, and plasma CVD treatment was conducted for 4 hours. The temperature of the substrate during plasma CVD treatment was measured by contacting a thermocouple placed on the specimen holder 106 with the back of the substrate. The temperature of the substrate was about 40°C throughout the plasma CVD treatment. By this plasma CVD treatment, a carbon film having a thickness of about 1 µm was deposited on the surface of the PPS resin substrate.

A Raman scattering spectral spectrum (excitation light wavelength: 244 nm) of a laminate of the PPS resin substrate having deposited thereon a plasma-resistant film and the carbon film, prepared by the above method is shown in Fig. 7. As shown in Fig. 7, a distinct peak positioned in the vicinity of a Raman shift of 1,333 cm⁻¹ is observed in the Raman scattering spectrum of the laminate, and it is apparent that a carbon film was deposited. The same measurement was conducted on other many samples prepared in the same manner as above. As a result, the peak is observed in a range of from 1,320 to 1,340 cm⁻¹, and it was found that the peak is necessarily fallen in a range of 1,333 ± 10 cm⁻¹. Furthermore, a broad peak observed in the vicinity of a Raman shift of 1,600 cm⁻¹ shows the presence of sp² bonding component of carbon. Full width of half maximum (FWHM) of a peak positioned in the vicinity of a Raman shift of 1,333 cm⁻¹ in this case was about 22 cm⁻¹.

The same measurement was conducted on other many samples. As a result, it was found that FWHM is fallen within in a range of from 10 to 40 cm⁻¹.

In this embodiment, argon gas was not added. However, because a plasma-resistant film was provided on the surface of the PPS resin substrate, damage on the surface of the substrate was not generated even though argon gas was not added. Of course addition of argon gas was also effective for the formation of a carbon film.

### (Example 2: Formation of carbon film on PPS substrate having provided thereon plasma-resistant film (Cu))

A material obtained by molding a polyphenylene sulfide (PPS) resin into a plate by injection molding was used as a substrate. Specifically, PPS resin TORELINA A310M, a product of Toray Industries, Inc., was used as a PPS resin. This A310M is a PPS resin having been reinforced with glass fibers and inorganic fillers. This was injection molded using an injection molding apparatus having a degassing equipment (Model Number: ECOMAK HS100) in injection molding machine, a product of Haruna, mounted on an injection molding machine (Model Number: ROBOSHOT α-100IA), a product of Fanuc Ltd. The degassing equipment in injection molding machine, a product of Haruna, is an apparatus which removes outgas and water generated by resin raw materials during plasticizing in a cylinder of an injection molding machine. The PPS resin substrate had a shape of 100 mm × 100 mm and 2 mm thickness. An average surface roughness of the surface of the PPS resin substrate was 3.5 µm by the observation of a region of 10 µm × 10 µm using an atomic force microscope.

Copper having a thickness of 1 µm was formed as a plasma-resistant film on the surface of the PPS resin substrate by a sputtering method. A pre-treatment of adhering nanocrystallyne diamond particles and the like, as applied to the PPS resin substrate having titanium as a plasma-resistant film formed thereon was not conducted in the PPS resin substrate having provided thereon the copper as a plasma-resistant film. In the PPS resin substrate having copper as a plasma-resistant film formed thereon, growth deposition of a carbon film was possible without conducting a pre-treatment of adhering nanocrystallyne diamond particles and the like, as described hereinafter. Of course, a pre-treatment of adhering nanocrystallyne diamond particles and the like may be conducted for the deposition and growth of a carbon film on a PPS resin substrate having provided thereon copper as a plasma-resistant film.

A carbon film was formed on the PPS resin substrate using a plasma CVD apparatus shown in Fig. 4 as follows.

A gas used in the CVD treatment was composed of 90 mol% of hydrogen gas, 5 mol% of carbon dioxide and 5 mol% of methane gas. Plasma was generated at a gas pressure of 10 Pa, a substrate was placed at a position of 50 mm from a quartz window at which electron temperature of plasma is 1 eV, and plasma CVD treatment was conducted for 4 hours. The temperature of the substrate during plasma CVD treatment was measured by contacting a thermocouple placed on the specimen holder 106 with the back of the substrate. The temperature of the substrate was about 40°C throughout the plasma CVD treatment. By this plasma CVD treatment, a carbon film having a thickness of about 1 µm was deposited on the surface of the substrate.

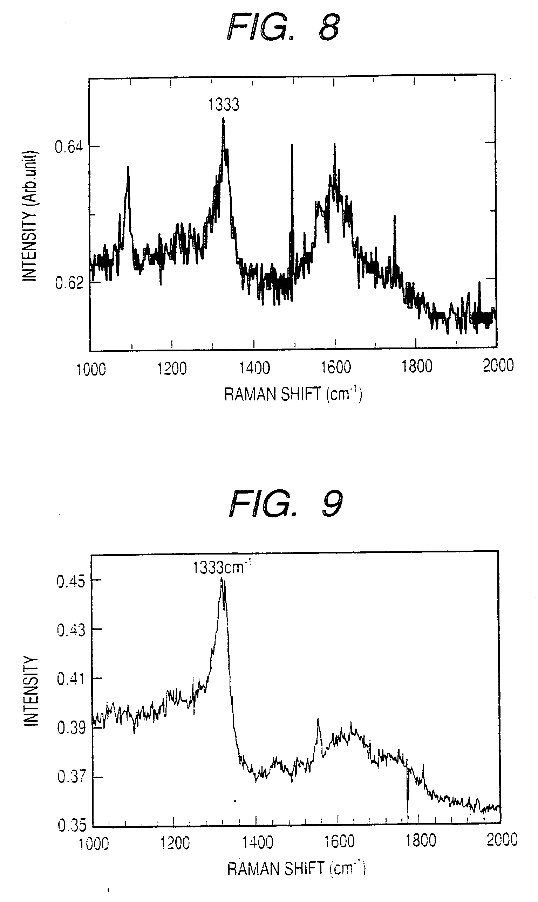

A Raman scattering spectral spectrum (excitation light wavelength: 244 nm) of a laminate of the PPS resin substrate having deposited thereof a plasma-resistant film (Cu) and the carbon film, prepared by the above method is shown in Fig. 8. As shown in Fig. 8, a distinct peak positioned in the vicinity of a Raman shift of 1,333 cm⁻¹ is observed in the Raman scattering spectrum of the laminate, and it is apparent that a carbon film was deposited. Thus, in the PPS resin substrate having provided thereon Cu as a plasma-resistant film, growth deposition of a carbon film was possible even though a pre-treatment of adhering nanocrystalline diamond particles and the like was not conducted. The same measurement was conducted on other many samples prepared in the same manner as above. As a result, the peak is observed in a range of from 1,320 to 1,340 cm⁻¹, and it was found that the peak is necessarily fallen in a range of 1,333 ± 10 cm⁻¹. Furthermore, a broad peak observed in the vicinity of a Raman shift of 1,600 cm⁻¹ shows the presence of sp² bonding component of carbon. Full width of half maximum (FWHM) of a peak positioned in the vicinity of a Raman shift of 1,333 cm⁻¹ was about 22 cm⁻¹. The same measurement was conducted on other many samples. As a result, it was found that FWHM is fallen within a range of from 10 to 40 cm⁻¹.

In this embodiment, argon gas was not added. However, because a plasma-resistant film was provided on the surface of the PPS resin substrate, damage on the surface of the substrate was not generated even though argon gas was not added. Of course addition of argon gas was also effective for the formation of a carbon film.

### (Example 3: Formation of carbon film on PPS substrate which does not have plasma-resistant film thereon)

A material obtained by molding a polyphenylene sulfide (PPS) resin into a plate by injection molding was used as a substrate. Specifically, PPS resin TORELINA A504X90, A310M and A900, products of Toray Industries, Inc., were used as the PPS resin. A504X90 is a PPS resin having been subjected to glass fiber reinforcement, A310M is a PPS resin having been reinforced with glass fibers and inorganic fillers, and A900 is a PPS resin which is not reinforced with glass fibers or inorganic fillers. This was injection molded using an injection molding apparatus having a degassing equipment (Model Number: ECOMAK HS100) in injection molding machine, a product of Haruna, mounted on an injection molding machine (Model Number: ROBOSHOT α-100IA), a product of Fanuc Ltd. The degassing equipment in injection molding machine, a product of Haruna, is an apparatus which removes outgas and water generated by resin raw materials during plasticizing in a cylinder of an injection molding machine. The PPS resin substrate had a shape of 100 mm × 100 mm and 2 mm thickness. An average surface roughness of the surface of the PPS resin substrate was 3.5 µm by the observation of a region of 10 µm × 10 µm using an atomic force microscope.

A pre-treatment of adhering nanocrystalline diamond particles dispersed in water to those PPS resin substrates was conducted. That is, the PPS resin substrate was dipped in the dispersion and treated in an ultrasonic washer. Thereafter, the substrate was dipped in ethanol, followed by ultrasonic washing, and the substrate was taken out and dried. Thus, the PPS resin substrate having adhered on the surface thereof nanocrystallene diamond particles was obtained. Adhesion of the nanocrystallene diamond particles onto the PPS resin substrate is due to that a part of the particles is embedded in the surface of the substrate by physical force in the ultrasonic washing treatment. The diamond particles adhered to the PPS resin act as seed crystals of the growth of a carbon film in plasma CVD treatment.

A carbon film was formed on the PPS resin substrate having been subjected to the above pre-treatment, using a plasma CVD apparatus shown in Fig. 4 as follows.

A gas used in the CVD treatment was composed of 95 mol% of argon gas and 5 mol% of methane gas. In this embodiment, hydrogen gas and carbon dioxide were not added. Addition of hydrogen gas and carbon dioxide gas is effective for the formation of a carbon film. However, when hydrogen gas exceeds 50 mol%, plasma damage on the surface of the PPS resin substrate was vigorous and it was difficult to form a high quality laminate of a carbon film and a PPS resin. Plasma was generated at a gas pressure of 10 Pa, a substrate was placed at a position of 50 mm from a quartz window at which electron temperature of plasma is 1 eV, and plasma CVD treatment was conducted for 4 hours. The temperature of the substrate during plasma CVD treatment was measured by contacting a thermocouple placed on the specimen holder 106 with the back of the substrate. The temperature of the substrate was about 40°C throughout the plasma CVD treatment. By this plasma CVD treatment, a carbon film having a thickness of about 1 µm was deposited on the surface of the substrate.

A Raman scattering spectral spectrum (excitation light wavelength: 244 nm) of the laminate of the PPS resin substrate and the carbon film, prepared by the above method is shown in Fig. 9. The graph is an embodiment in the case of using TORELINA A310M, a product of Toray Industries, Inc, as the PPS resin. As shown in Fig. 9, a distinct peak positioned in the vicinity of a Raman shift of 1,333 cm⁻¹ is observed in the Raman scattering spectrum of the laminate, and it is apparent that a carbon film was deposited. The same measurement was conducted on other many samples prepared in the same manner as above. As a result, the peak is observed in a range of from 1,320 to 1,340 cm⁻¹, and it was found that the peak is necessarily fallen in a range of 1,333 ± 10 cm⁻¹. Furthermore, a broad peak observed in the vicinity of a Raman shift of 1,600 cm⁻¹ shows the presence of sp² bonding component of carbon. Full width of half maximum (FWHM) of a peak positioned in the vicinity of a Raman shift of 1,333 cm⁻¹ was about 22 cm⁻¹.

The same measurement was conducted on other many samples. As a result, it was found that FWHM is fallen within a range of from 10 to 40 cm⁻¹. Even in the case of using TORELINA A504X90 and A900, products of Toray Industries, Inc., deposition of a carbon film could be confirmed by a Raman scattering spectral spectrum, similar to A310M above.

The above is examples particularly using a PPS resin as a resin material. In the invention, preparation of laminates with a carbon film was tried using a polycarbonate (PC) resin, a polyethylene terephthalate (PET) resin and a polyether sulfone (PES) resin. In the case of providing a plasma-resistant film using those PC, PET and PES resin materials in the same manner as in the PPS resin, and in the case that a plasma resistant film is not formed, deposition of a carbon film was confirmed. Therefore, the method of the invention can be applied to PC, PET and PES resin materials, similar to the PPS resin material.

From the above, it is considered that the method of the invention can easily be applied to various kinds of resin materials not described in the present embodiments.

### (Example 4: X-ray diffraction of carbon film)

The laminate of the carbon film and the PPS resin of the invention was observed by X-ray diffraction. Details for the measurement are described below.

The X-ray diffraction apparatus used is an X-ray diffraction measuring apparatus, RINT2100 XRD-DSC II, a product of Rigaku Corporation, and a goniometer is Ultima III horizontal goniometer, a product of Rigaku Corporation. A multipurpose specimen holder for thin film standard is attached to the goniometer. The measured specimen is a carbon film having a film thickness of 500 nm deposited on a PPS resin substrate having a thickness of 2 mm of the invention. A piece cut to 30 mm square together with the PPS resin material was measured. X-ray used was copper (Cu) K_{α1} ray. The voltage and current applied to the X-ray tube were 40 kV and 40 mA. A scintillation counter was used for an X-ray detector. At first, the scattering angle (2θ angle) was calibrated by using a silicon standard specimen. Deviation of 2θ angle was +0.02° or less. Then, the measuring specimen was set to the specimen holder and the 2θ angle was adjusted to 0°, that is, was adjusted such that under the conditions that X-ray is directly incident to the detector, the X-ray incident direction and the specimen surface were in parallel and one-half of the incident X-rays is shielded by the specimen. The goniometer was rotated from the state and X-rays were irradiated at an angle of 0.5° relative to the specimen surface. The 2θ angle was rotated at 0.02° step from 10° to 90° while fixing the incident angle, and the intensity of X-rays scattering from the specimen at 2θ angle for each of them was measured. A computer program used for the measurement is RINT2000/PC software Windows (registered trademark) version, a product of Rigaku Corporation.

Fig. 10 shows a measured spectrum of X-ray diffraction. Blanc circles in the graph are measuring point. It can be seen that a distinct peak is present at 2θ of 43.9°. It is interesting, as can be seen from Fig. 10, that the peak at 43.9° has a shoulder at 2θ of 41 to 42° on the lower angle side thereof (for "shoulder" of the spectrum, refer to "Kagaku Daijiten (Chemical Encyclopedia)" (Tokyo Kagaku Dojin)). Accordingly, the peak comprises a two-component peak having a peak (first peak) about at 43.9° as a center and another peak (second peak) distributed about at 41 to 42°. In X-ray diffraction by CuK_{α1} rays, diamond has been known as a carbonaceous substance having a peak at 2θ of 43.9°. Fig. 11 is a spectrum measured for diamond by X-ray diffraction by the same method and the peak is attributable to (111) reflection of diamond. Difference of the X-diffraction spectrum between the carbon film of the laminate of the invention and diamond is clear, and the second peak distributed about at 41 to 42° appearing in the spectrum of the carbon film of the laminate of the invention cannot be seen in diamond. As described above, (111) reflection of diamond consists of the first component (only the first peak) at 43.9° as the center in which shoulder on the lower angle side as in the carbon film of the laminate obtained by the invention is not observed. Accordingly, the second peak distributed about at 41 to 42° observed in the spectrum of the carbon film of the invention is a peak inherent to the carbon film of the laminate obtained by the invention.

Further, it can be seen that the peak for the X-ray diffraction spectrum of the carbon film of the invention in Fig. 10 is much broaden when compared with the peak of diamond in Fig. 11. Generally, as the size of particles constituting the film decreases, the width of the X-ray diffraction peak is widened more and the size of the particles constituting the carbon film of the laminate obtained by the invention can be said to be extremely small. When the size of the carbon particle constituting the carbon film of the laminate obtained by the invention (average diameter) is estimated based on the width of the peak according to the Sherrer's formula usually used in the X-ray diffraction, it was about 15 nm. For the Sherrer's formula, refer, for example, to "Hakumaku (Thin Film) Handbook, edited by Japan Society for the Promotion of Science, Thin Film, 131st Committee, from Ohmusha Ltd., in 1983, p.375".

Then, details for the constitution of the peak (positions and strength for respective peak ingredients) are to be considered.

For determining the detailed constitution of the peak at 2θ of 43.9° in the X-ray diffraction measurement for the carbon film of the laminate obtained by the invention, analysis was conducted for 2θ angle from 39° and 48° by using peak fitting. For the fitting of the first peak, a function called as a Pearson VII function was used. The function is used most generally as representing the profile of peak in the diffraction method such as X-ray diffraction or neutron diffraction. The Pearson VII function can be referred to "Introduction Practice of Powder X-ray Analysis - Introduction to Rietveld Method" (edited by X-ray Analysis Study Conference of Japan Society for Analytical Chemistry, Asakura Shoten). Further, as a result of study for various functions, it has been found that an asymmetric function is preferably used for the fitting of the second peak. In this example, an asymmetric normal distribution function (Gaussian distribution function) was used. The function is a normal distribution function having separate dispersion (standard deviation) values on the right and the left of the peak position, which is one of simplest functions as a function used for the fitting of an asymmetric peak, and could fit to peak extremely favorably. Further, a linear function (primary function) was used as a base line (background) function.

While various computer programs can be utilized for actual fitting operation, ORIGIN version 6, peak fitting module Japanese edition (hereinafter as ORIGIN-PFM) was used. In ORIGIN-PFM, the Pearson VII function is represented as "Pearson 7", the asymmetric normal distribution function is represented as "BiGauss", and the linear function is represented as "Line". The completion condition for fitting is defined such that the correlation coefficient representing the reliability of the fitting ("COR", or "Corr Coef" in ORIGIN-PFM) is 0.99 or more.

According to the analysis using the peak fitting, as shown in Fig. 10, it can be seen that the measured spectrum can be approximated well as the sum for the first peak according to the Pearson VII function (fitting curve A in the graph), a second peak according to the asymmetric normal distribution function (fitting curve B in the graph) and the base line according to the primary function (background) (total fitting curve in the graph). In the measurement, the center for the fitting curve A is at 2θ of 43.9°, while the fitting curve B has a maximum at 41.7°. Areas surrounded by respective fitting curves and the base line are respective peak intensities. Thus, the intensity of the second peak to the intensity of the first peak was analyzed. In the case of this specimen, the intensity of the second peak (fitting curve B) was 45.8% for the intensity of the first peak (fitting curve A).

When X-ray diffraction measurement was conducted for many specimens of the carbon film of the laminate obtained by the invention, a broad peak as shown in Fig. 10 was observed around 2θ of 43.9° as the center for all of the specimens. In addition, they were in a shape having a shoulder on the lower angle side as shown in Fig. 10, and comprised of the first peak and the second peak. When analysis was conducted by the same peak fitting for the X-ray diffraction spectrum measured for many specimens, it was found that fitting could be conducted well by using the functions described above. The center for the first peak was at 2θ of 43.9 ± 0.3°. Further, it was found that the second peak had a maximum at 2θ of 41.7 ± 0.3°. The intensity ratio to the first peak was 5% at the minimum and 90% at the maximum. The intensity ratio had large dependence on the synthesis temperature and it tended to increase as the temperature was lower. On the other hand, the peak position was substantially constant irrespective of the synthesis temperature.

What is to be noted for the analysis method of the X-ray diffraction measurement is that measured data scatter greatly as the intensity of the X-ray is smaller and no reliable fitting is possible. Accordingly, it is necessary to conduct the analysis by the fitting for those having the maximum intensity of the peak of 5000 counts or more.

As described above, it was found that the carbon film of the laminate obtained by the invention has a broad peak around 2θ of 43.9° as the center in the measurement of X-ray diffraction by CuK_{α1} rays, and that the peak has a structure with a shoulder on the lower angle side. It was found by the analysis using the peak fitting that the peak could be approximated well by superimposing the first peak using the Pearson VII function having a center at 2θ of 43.9°, the second peak using the asymmetric normal distribution function being maximum at 41.7°, and the base line with the primary function (background).

Analysis by fitting was conducted in the same manner for the spectrum of diamond shown in Fig. 11. It was found that the peak could be approximated well only with the Pearson VII function having a center at 2θ of 43.9° in a case of diamond, quite different from the carbon film of the laminate obtained by the invention described above. Accordingly, it was found that the carbon film of the laminate obtained by the invention was a substance having a structure different from that of diamond.

The carbon film of the laminate obtained by the invention has a feature in that the second peak described above is observed and this is a carbon film having a structure different from that of diamond. The production step of the carbon film of the laminate obtained by the invention and the result of other measurements were studied and the structure was investigated. The synthesis method of the carbon film in the laminate obtained by the invention has the following remarkable feature when compared with the CVD synthesis method for diamond. At first, while usual synthesis for the diamond has been conducted at a temperature of at least 700°C or higher, the carbon film of the laminate obtained by the invention is synthesized at extremely low temperature. Further, in a case of decreasing the grain size of the diamond film, a method of rapidly growing at a high concentration of about 10% for the concentration of the carbon source (molar ratio of methane gas) contained in the starting gas has been employed so far, the concentration of the carbon source in the invention is rather low as about 1%. That is, in this method, carbon particles are deposited at low temperature extremely slowly for a long time to form a film. Accordingly, the carbon particles are deposited at a breaking situation where they are transformed to diamond or not. Accordingly, a force of promoting deposition of hexagonal phase diamond which is carbon crystals more stable than the usual cubic phase diamond or deposition of further stable graphite acts, and this is extremely unstable as the state of crystal deposition. Further, once deposited graphite and amorphous carbonaceous substance are also removed by etching by hydrogen plasmas contained in the starting gas. By means of such a deposition mechanism, they form a structure in which cubic phase diamond and hexagonal phase diamond are mixed, and portions removed by etching remain as defects at an extremely high concentration. Such defects are point defects as atomic vacancy, linear defects as relocation, or defects on the basis of the surface unit such as lamination defects, and are also contained in a great amount. Accordingly, it forms a structure in which X-ray diffraction peak at 43.9° has a shoulder on the lower angle side.

However, the feature of the X-ray diffraction peak described above is in association with high function of the carbon film of the laminate according to the invention. That is, while a structure containing defects at high concentration is formed since etching for graphite or graphite like substance is promoted due to the low speed synthesis at a low concentration of the carbon source, heat conductivity, strength, hardness and transparency of the carbon film is kept high. Further, while the cubic phase diamond and the hexagonal phase diamond are mixed and defects at a high concentration are contained due to synthesis at low temperature, direct coating without giving thermal damage to the resin material was possible by virtue of such low temperature. Fine grain sizes of carbon particles in the carbon film are uniform due to synthesis at low temperature and thermal strain is extremely small. That is, the structure in which the cubic phase diamond and the hexagonal phase diamond are mixed and defects at an extremely high concentration are contained results in a feature that the thermal strain is moderated and the optical birefringence is small. Further, an extremely high electric insulating property is developed by virtue of the structure in the same manner.

### (Example 5: Electric resistance measurement and Hall effect measurement of carbon film)

For recognizing the electric characteristic of the carbon film of the laminate obtained by the invention, electric resistance measurement and Hall effect measurement were conducted. Details for the measurements are described below. An electric resistance measuring apparatus and a Hall effect measuring apparatus used were ResiTest Model 8310S equipment manufactured by Toyo Corporation. Further, a specimen holder used was model VHT manufactured by Toyo Corporation. The measured specimen was a carbon film of 500 nm thickness prepared on a PPS resin substrate of 2 mm thickness by the method of the invention. Those cut out together with the PPS substrate each into 4 mm square were measured. Ti was deposited to 50 nm in a circular shape of 0.3 mm diameter by vacuum vapor deposition to four corners of the specimen as an electrode. Further, Pt was vapor deposited to 50 nm and Au was vapor deposited to 100 nm thereon to prevent oxidation of the Ti electrode. The specimen was mounted on a specimen holder made of high resistance alumina, and wiring was conducted by ultrasonic bonding of a gold wire having a diameter of 250 µm to the electrode.

Measurement for the electric resistance was conducted in an atmosphere of helium at 1 mbar. Measurement was conducted each at room temperature and 100°C. As a result, the measurement showed high resistance values of 1 × 10⁹ Ωcm or more at 100°C and 1 × 10¹⁰ Ωcm or more at room temperature (20°C).

The type of electroconductivity was tried to determine by the Hall effect measurement, but the type could not be judged as to whether it is p-type or n-type due to high resistance.

The above electrical properties show that the carbon film of the laminate obtained by the invention functions as an electrical insulating film very well.

### (Example 6: Measurement of thermal conductivity of carbon film)

The measurement of thermal conductivity of the carbon film formed on the PPS resin of the invention was conducted. The thickness of the carbon film is 1 µm. The measurement method used was a light alternating-current method. (Regarding the light alternating-current method, refer to "Calorimetry and Thermal Analysis Handbook", edited by Japan Society of Calorimetry and Thermal Analysis, from Maruzen Co., Ltd.). As a result, thermal diffusivity at 25°C was obtained. At the same time, specific heat and density of the carbon film of the laminate were measured. Those are multiplied by the thermal diffusivity, and the following thermal conductivity was obtained in two samples of the carbon film obtained by the invention.
Sample (1): 70 to 500 W/mk
Sample (2): 110 to 700 W/mk

### (Example 7: Measurement of thermal conductivity of carbon film)

The thermal conductivity measurement of the carbon film formed on the PPS resin obtained by the invention was conducted using a laser flash method, different from the above light alternating-current method. In this measurement method, thermal conductivity measurement in a state that a carbon film is deposited on the PPS resin substrate is difficult. Therefore, a quartz glass was used as a substrate. A carbon film was deposited on a quartz glass substrate, and evaluation of thermal conductivity of the carbon film was conducted. A carbon film having a film thickness of 1 µm was formed on a quartz glass substrate having 5 mm × 5 mm and a thickness of 100 µm. Thirty laminates thereof were piled to prepare a rectangular solid-like sample having 5 mm × 5 mm and a lateral face thickness of about 3 mm. The lateral face having a thickness of about 3 mm was irradiated with infrared laser, and thermal diffusivity in an in-plane direction of the quartz glass having a carbon film formed thereon by the laser flash method was obtained. The infrared laser-irradiated face was subjected to blackening treatment in order to increase absorption of infrared rays. (In measurement by laser flash method used in this Example and data analysis, the method described in "Newest Thermometry - From Base to Application -", (supervised by Ichiro Hatta, edited by Ulvac-Riko, Inc., Agune Gijyutu Center) was followed). At the same time, thirty quartz glass substrates having no carbon film were piled to prepare a rectangular solid-like sample, and thermal diffusivity of only the quartz glass substrate was measured. From the above measurements, the thermal diffusivity of the quartz glass substrate having a carbon film and that of the quartz glass substrate having no carbon film were compared, and the thermal diffusivity at 20°C in an in-plane direction of only the carbon film was obtained. Furthermore, specific heat and density of the carbon film of the laminate were measured. Those were multiplied by the thermal diffusivity, and the following thermal conductivity was obtained in two samples of the carbon film obtained by the invention.
Sample (3): 150 to 600 W/mK
Sample (4): 70 to 700 W/mK

### (Example 8: Verification of scratch prevention effect)

Verification of scratch prevention effect of the carbon film of the laminate obtained by the invention was conducted. The carbon film obtained by the invention was laminated in a thickness of 300 nm on the surface of a PPS resin material having a diameter of 10 cm and a thickness of 1 mm. The resulting laminate was rubbed with a #1000 sand paper by reciprocating the same 100 times, but scratches were not formed at all. On the other hand, scratches are apparently formed on the PPS resin material not having a carbon film laminated thereon. Thus, it was found that the carbon film of the laminate obtained by the invention has high scratch prevention effect for the PPS resin material.

### INDUSTRIAL APPLICABILITY

The laminate of a carbon film and a resin obtained by the present invention has the characteristics described above, and therefore can be used in applications such as a heat sink of electronic instruments such as personal computers or multi-media relations, and reduction in weight by substitution of machinery parts and structural parts with a resin.

## Claims

1. A method for depositing a carbon film on a substrate containing a resin material providing a maximal surface roughness of 3.5 µm or less, the method comprising introducing, as a reaction gas, a mixed gas of a carbon-containing gas and an argon gas and/or a hydrogen gas into a microwave plasma CVD reactor, generating a plasma at a gas pressure of from 1 to 100 pascals, placing the substrate at a position at which an electron temperature of the plasma is from 0.5 to 3.0 eV, and moving radical species in the plasma toward the substrate from a generation source of the plasma such that the radical species almost uniformly reach on a surface of the substrate.

2. The method according to claim 1, wherein the substrate has a plasma-resistant film.

3. The method for depositing a carbon film according to claim 1 or 2, wherein the substrate containing the resin material is maintained at a temperature of from room temperature to 200° C.

4. The method for depositing a carbon film according to claim 1 or 2, wherein the substrate containing the resin material is pretreated by ultrasonic waves or spin coating.

## Patentansprüche

1. Verfahren zum Abscheiden eines Kohlenstofffilms auf einem Substrat mit einem Harzmaterial, das eine maximale Oberflächenrauigkeit von 3,5 µm oder weniger bereitstellt, wobei das Verfahren umfasst: Einbringen eines Gasgemischs von Kohlenstoff-enthaltendem Gas und einem Argon-Gas und/oder einem Wasserstoff-Gas als ein Reaktionsgas in einen Mikrowellen Plasma-CVD-Reaktor, Erzeugen eines Plasmas bei einem Gasdruck zwischen 1 und 100 Pascal, Platzieren des Substrats an eine Position, bei der eine Elektronentemperatur des Plasmas zwischen 0,5 und 3,0 eV ist, und Bewegen von radikalen Spezies in dem Plasma von einer Erzeugungsquelle des Plasmas in Richtung des Substrats, so dass die radikalen Spezies eine Oberfläche des Substrats fast einheitlich erreichen.

2. Verfahren nach Anspruch 1, wobei das Substrat einen Plasma-resistenten Film aufweist.

3. Verfahren zum Abscheiden eines Kohlenstofffilms nach Anspruch 1 oder 2, wobei das Substrat, das das Harzmaterial aufweist, auf einer Temperatur zwischen Raumtemperatur und 200 °C gehalten wird.

4. Verfahren zum Abscheiden eines Kohlenstofffilms nach Anspruch 1 oder 2, wobei das Substrat, das das Harzmaterial aufweist, mit Ultraschallwellen oder Rotationsbeschichten vorbehandelt wird.

## Revendications

1. Procédé de dépôt d'une pellicule de carbone sur un substrat contenant un matériau de résine présentant une rugosité de surface maximale de 3,5 µm ou moins, le procédé comprenant l'introduction, comme gaz de réaction, d'un gaz mixte constitué d'un gaz contenant du carbone et d'un gaz argon et/ou d'un gaz hydrogène dans un réacteur CVD plasma à micro-ondes, le fait de générer un plasma à une pression de gaz comprise entre 1 et 100 pascals, le fait de placer le substrat dans une position dans laquelle une température électronique du plasma est comprise entre 0,5 et 3,0 eV, et le fait de déplacer des espèces radicales dans le plasma vers le substrat depuis une source de génération du plasma de telle sorte que les espèces radicales arrivent quasiment uniformément sur une surface du substrat.

2. Le procédé selon la revendication 1, sachant que le substrat comporte une pellicule résistante au plasma.

3. Le procédé de dépôt d'une pellicule de carbone selon la revendication 1 ou 2, sachant que le substrat contenant le matériau de résine est maintenu à une température comprise entre la température ambiante et 200°C.

4. Le procédé de dépôt d'une pellicule de carbone selon la revendication 1 ou 2, sachant que le substrat contenant le matériau de résine est prétraité par ondes ultrasoniques ou par enduction centrifuge.
